# EUROPEAN PATENT APPLICATION

(11) **EP 2 637 222 A2**
(43) Date of publication of application: **11.09.2013**
(21) Application number: 11838224.1
(22) Date of filing: 02.11.2011
(51) Int. Cl.: H01L 33/20, H01L 33/16

(54) **SEMICONDUCTOR DEVICE AND A MANUFACTURING METHOD THEREOF**

(30) Priority: 03.11.2010 KR 20100108670
(71) Applicant: Verticle, Inc., Seoul 121-835 (KR)
(72) Inventor: PARK, Moo Keun, Yongin-si Gyeonggi-do 446-916 (KR); YOO, Myung Cheol, Seoul 137-070 (KR); OH, Se Jong, Anseong-si Gyeonggi-do 456-724 (KR)
(74) Representative: Bockhorni, Josef
(86) International application number: PCT/KR2011/008275
(87) International publication number: WO 2012/060619

(57) **Abstract**

The present invention relates to a semiconductor device capable of emitting light upon application of voltage and a method for manufacturing the same, and more particularly to a semiconductor device having a polygonal or circular columnar shape and a method for manufacturing the same. The semiconductor device of the present invention comprises a plurality of semiconductor structures and a connecting support layer that supports the plurality of the semiconductor structures, wherein each of the plurality of the semiconductor structures comprises a P-type first semiconductor layer, an N-type second semiconductor layer, and a light-emitting layer located between the first semiconductor layer and the second semiconductor layer, and forms a column having a polygonal or circular shape.

## Description

### CROSS-REFERENCE TO RELATED APPLICATION

This application is a continuation of PCT/KR2011/008275 filed on November 02, 2011, which claims priority to Korean Application No. 10-2010-0108670 filed on November 03, 2010, which applications are incorporated herein by reference.

### TECHNICAL FIELD

The present invention relates to a semiconductor device capable of emitting light upon injection of an electric current and a manufacturing method thereof and more particularly to a semiconductor device having a polygonal or circular columnar shape, and a manufacturing method thereof

### BACKGROUND ART

Generally, a semiconductor device, which has a PN junction and emits light when a current is injected in the forward direction, is referred to as a light-emitting diode (LED). A light-emitting diode has advantages in that it can simply emit light at a desired frequency, is small in size, and has strong vibration resistance, low power consumption and long life expectancy, compared to a filament bulb.

Gallium-nitrogen (GaN) based light-emitting diodes have been developed which can easily emit green light. Thus, lights having various colors can be embodied using light-emitting diodes, and the range of application of light-emitting diodes has been expanded.

Light-emitting diodes are generally formed by depositing a GaN-based semiconductor device layer on a substrate, and a process of obtaining individual light-emitting diode devices by separating the semiconductor device layer from the substrate is required.

Conventional methods for separating individual light-emitting diodes from each other include a dicing method comprising cutting a substrate with a rotating blade, and a scribing method which comprises forming a groove in a substrate, and then cutting the substrate in a desired direction by applying stress. It is widely known that these methods cause damage to light-emitting diode devices during the separation process, resulting in a significant reduction in yield. In addition, in the dicing and scribing methods, light-emitting diodes fabricated in a wafer unit can only be separated in a straight line, and thus are typically separated mainly in a parallelogrammic or rectangular shape. Due to the limitation of the separation process, there is a limitation with regard to the shape that one light-emitting diode can have. This limitation reduces the street line versus the area of light-emitting diodes on a wafer, thus limiting any attempt to increase the light-emitting efficiency.

When light-emitting diodes are used for lighting, circular lenses are used in a packaging process in order to efficiently extract light from the light-emitting diodes. In order to increase light extraction efficiency, the shape of the light-emitting side of the light-emitting diodes should be optimally suited to the shape of the circular lenses. However, attempts to increase light extraction efficiency have been difficult due to the limitation of the separation process as described above.

### SUMMARY OF THE DISCLOSURE

Accordingly, the present invention has been made in order to solve the above-described problems occurring in the prior art, and an object ofthe present invention is to provide a method for manufacturing a semiconductor device in any polygonal or circular columnar shape and a semiconductor device manufactured by the method. When the semiconductor device manufactured according to the present invention is applied as a light-emitting diode device, even in a field in which its application is not necessarily limited, the light extraction efficiency can be maximized, because the light-emitting side thereof may have a circular shape or any polygonal shape.

Another object ofthe present invention is to provide a light-emitting diode device having increased light-emitting efficiency as a result ofreducing the street line versus the area.

Still another object ofthe present invention is to provide a semiconductor device having increased light extraction efficiency by fabricating a light-emitting diode so that the shape ofthe light-emitting diode is similar to the shape of a circular lens such as that which is generally used.

Yet another object of the present invention is to provide an electrode structure which optimizes heat transfer and current spreading when a light-emitting diode device has any polygonal or circular shape.

In order to accomplish the above objects, an embodiment of the present invention provides semiconductor devices, each comprising a P-type semiconductor layer, an N-type semiconductor layer and a light-emitting layer, in which each of individual semiconductor devices forms a polygonal or circular column. The light-emitting layer is located between the P-type semiconductor layer and the N-type semiconductor layer.

The plurality of the semiconductor devices, formed on a wafer and each having a polygonal or circular columnar shape, may be periodically or regularly spaced apart from each other. The semiconductor device may have a polygonal shape so that a street line of the semiconductor device versus an area of the semiconductor device can be minimized. Herein, an example of the polygonal shape may be a hexagonal shape. When the hexagonal semiconductor devices are arranged in a crossing pattern, the distance therebetween can be minimized. This arrangement structure is also called a honeycomb structure. Alternatively, the semiconductor device may have a circular shape so as to minimize the street line versus the area.

The shape of the semiconductor devices and a boundary therebetween can be determined according to a crystal structure of the semiconductor. For example, a GaN-based light-emitting diode device may have a hexagonal columnar shape according to the (0001) crystal structure.

In addition, a plurality of semiconductor devices according to an embodiment of the present invention may be formed on the same connection support layer and may be connected by the connection support layer. Herein, the connection support layer may be formed of a metal layer or a metal compound. Alternatively, it may be formed of a compound comprising at least one of Si, GaN, Al2O₃ and SiC.

Further, a method for manufacturing a semiconductor according to an embodiment of the present invention comprises the steps of forming a semiconductor structure layer on a substrate; depositing a metal layer on the surface of the semiconductor structure layer; exposing the semiconductor structure layer by separating the semiconductor structure layer and the metal layer from the substrate; forming a plurality of individual semiconductor devices having a polygonal or circular shape by etching the semiconductor structure layer according to a first mask pattern; and separating the individual semiconductor devices from each other by dry-etching or wet-etching the metal layer according to a second mask pattern corresponding to the first mask pattern so that the metal layer remains as a plurality of polygonal or circular shapes.

The plurality of the individual semiconductor devices having a polygonal or circular columnar shape are supported by the metal layer before separation. The individual semiconductor devices are separated from each other by etching the metal layer to correspond to the shape of the individual semiconductor devices.

A method for manufacturing a semiconductor device according to another embodiment of the present invention comprises the steps of forming a semiconductor structure layer on a substrate, and then depositing a mask layer on a boundary region excluding a device region of a surface of the semiconductor structure layer, in which a semiconductor device is to be formed; depositing a metal layer on the exposed surface of the semiconductor structure layer, on which the mask was not deposited; exposing the semiconductor structure layer by separating the semiconductor structure layer from the substrate; forming a plurality of the individual semiconductor devices having the polygonal or circular shape by etching the semiconductor structure layer according to a mask pattern corresponding to the boundary region; and separating the individual semiconductor devices from each other by removing the mask layer from the boundary region.

In this embodiment, before the individual semiconductor devices are separated from each other, a support layer capable of connecting and supporting the individual semiconductor devices may further be deposited on the surface of the metal layer or a surface opposite the metal layer. Alternatively, a support member such as a support tape may be adhered to the surface of the metal layer or a surface opposite the metal layer.

A method for manufacturing a semiconductor according to still another embodiment of the present invention comprises the steps of forming a plurality of semiconductor structures having a polygonal or circular columnar shape on a substrate; depositing a metal layer on the surface of the plurality of the semiconductor structures; exposing the plurality of the semiconductor structures by separating the plurality of the semiconductor structures and the metal layer from the substrate; providing a first mask pattern corresponding to one or more semiconductor structure groups comprising selectively one or more of the plurality of the semiconductor structures; and separating the one or more semiconductor structure groups from each other to form individual semiconductor devices by dry-etching or wet-etching the plurality of the semiconductor structures and the metal layer using the first mask pattern. Herein, the resulting individual semiconductor devices may comprise one or more semiconductor structures having a polygonal or circular column.

The first mask pattern may be the same as or differ from a mask pattern for forming semiconductor structures into polygonal or circular columns. According to the above method, the semiconductor structures may be formed to have the smallest possible size, but the plurality of semiconductor devices may also be separated at the same time as an individual semiconductor device by using a larger first mask pattern in the separation process.

A method for manufacturing a semiconductor according to still another embodiment of the present invention comprises the steps of forming a plurality of semiconductor structures having a polygonal columnar or circular columnar shape on a substrate; providing a first mask pattern corresponding to one or more semiconductor structure groups comprising one or more of the plurality of the semiconductor structures; depositing a mask layer on a boundary region other than the one or more semiconductor structure groups using the first mask pattern; depositing a metal layer corresponding to the one or more semiconductor structure groups using a second mask pattern corresponding to the first mask pattern; separating and removing the substrate from the plurality ofthe semiconductor structures; forming individual semiconductor devices corresponding to the one or more semiconductor structure groups by dry-etching or wet-etching the plurality of the semiconductor structures using the first mask pattern; and separating the individual semiconductor devices from each other by removing the mask layer from the boundary region.

A support layer may additionally be formed on or adhered to the metal layer or a surface opposite to the metal layer, and the additional support layer may connect and support the plurality of individual semiconductor devices until the individual semiconductor devices are separated from each other.

The individual semiconductor devices separated from each other comprise one or more previously formed polygonal column-shaped or circle-shaped devices.

A method for manufacturing a semiconductor according to another embodiment of the present invention comprises the steps of forming on a substrate a plurality of semiconductor structures which have a polygonal columnar or circular columnar shape and are periodically spaced apart from each other; depositing a metal layer on the plurality of the semiconductor structures or on a boundary between the semiconductor structures; irradiating the substrate with a laser, which corresponds to a shape of one of the plurality of the semiconductor structures or a shape of a group including two or more of the plurality of the semiconductor structures and has a uniform beam profile, in a direction perpendicular to the substrate so that the laser is absorbed into a boundary between the plurality of the semiconductor structures and the substrate; and separating one or more of the plurality of the semiconductor structures from the substrate by the absorbed laser.

Herein, the beam profile may be irradiated into the boundary between one of the semiconductor structures and the substrate so that the one semiconductor structure is separated as one chip. Alternatively, the beam profile may be irradiated into the plurality of periodically arranged semiconductor structures so that the plurality of semiconductor structures may be separated from the substrate at the same time.

A method for manufacturing a semiconductor according to another embodiment of the present invention comprises the steps of forming a semiconductor structure layer on a substrate; depositing a mask layer on a boundary region excluding a device region of a surface of the semiconductor structure layer, in which individual semiconductor devices are to be formed and which has a polygonal or circular shape; depositing a first metal layer on the device region of the surface of the semiconductor structure layer; removing the mask layer from the boundary region; depositing a second metal layer on the boundary region and the first metal layer; exposing the semiconductor structure layer by separating the semiconductor structure layer from the substrate; forming a plurality of the individual semiconductor devices having a polygonal columnar or circular columnar shape by etching the semiconductor structure layer according to a mask pattern corresponding to the boundary region; and separating the individual semiconductor devices from each other by etching a portion of the second metal layer, deposited on the boundary region, according to the mask pattern corresponding to the boundary region.

According to this embodiment, the first metal layer is selectively deposited only on the device region, and the second metal layer is deposited on the whole region. A portion of the second metal layer, which corresponds to the boundary region, is etched by a subsequent etching process. Thus, the time required to etch the metal layers can be controlled by suitably selecting the thicknesses of the first metal layer and the second metal layer.

In addition, a light-emitting diode device according to one embodiment of the present invention comprises an electrode formed on the surface of the semiconductor, and a finger connected to the electrode. The electrode and the finger are made of a conductive material, and when voltage is applied through the electrode, an electric current is diffused to the surface of the semiconductor device through the finger. In some embodiments, the finger may comprise an inner finger and an outer finger, and the inner finger and the outer finger are connected to each other by a connection finger. The distance of the finger from any point on the surface of the semiconductor device may be set at a specific value or less. When this finger is formed, an electric current is rapidly transferred to any point on the surface of the semiconductor. The finger may also be called an extension of the electrode.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a top view showing a plurality of semiconductor chips according to an embodiment ofthe present invention.
FIG. 2 shows a semiconductor device according to an embodiment of the present invention.
FIG. 3 is a perspective view showing an example of the arrangement of the semiconductor devices 200 shown in FIG. 2.
FIGS. 4 to 6 show various examples of electrodes and fingers for the semiconductor device 110 shown in FIG. 1.
FIG. 7 is a top view showing a plurality of semiconductor devices according to another embodiment of the present invention.
FIG. 8 shows a semiconductor device according to another embodiment of the present invention.
FIGS. 9 and 10 show various examples of electrodes and fingers for the semiconductor device 710 shown in FIG. 7.
FIGS. 11 to 13 are cross-sectional views showing a first embodiment of the inventive method for manufacturing a semiconductor device according to the present invention
FIGS. 14 and 15 are cross-sectional views showing a second embodiment of the inventive method for manufacturing a semiconductor device according to the present invention.
FIG. 16 shows various examples of mask patterns, which are used for selective etching of metal layers 1140 and 1440, selective formation of a mask layer 1441 or etching of semiconductor structure layers 1120, 1130, 1420 and 1430 in the inventive method for manufacturing a semiconductor device according to the present invention.
FIG. 17 shows various examples of mask patterns which are used for selective formation of metal layers 1140 and 1440 in the inventive method for manufacturing a semiconductor device according to the present invention.
FIG. 18 is a cross-sectional view showing a semiconductor device 1800 according to another embodiment of the present invention.
FIGS. 19 to 21 are cross-sectional view showing a third embodiment of the inventive method for manufacturing a semiconductor device according to the present invention.
FIG. 22 shows a semiconductor having a honeycomb structure according to an embodiment.

### DETAILED DESCRIPTION OF THE DISCLOSURE

Hereinafter, embodiments of the present invention will be described in detail with reference to the accompanying drawings. However, the scope of the present invention is not limited or restricted to these embodiments. In the drawings, like reference numerals indicate like elements.

Each region in the drawings may be simplified or somewhat exaggerated to clearly show the features of the present invention, and the dimensions of each region in the drawings may not be exactly identical to the actual dimensions of the products of the present invention.

Any person skilled in the art may easily modify the dimensions (e.g., length, circumstance, thickness, etc.) of each element in the drawings and apply these modifications to actual products, and these modifications will fall within the scope of the present invention.

The biggest characteristic of the light-emitting diode semiconductor devices according to the present invention is that they may have any shape and arrangement.

Specifically, the shape of the semiconductor devices of the present invention may be determined by any one of the following requirements. First, the semiconductor devices may have a shape that minimize the street line versus the surface area of the light-emitting side. Ideally, a circular shape satisfies this requirement, but a shape such as a hexagonal or octagonal shape that is relatively similar to a circular shape can be applied in some embodiments. Second, the semiconductor devices may have a shape that minimizes the surface area of the light-emitting side. Third, the semiconductor devices may have a shape that reflects the crystal structure of a semiconductor on which light-emitting diodes are based. Fourth, the semiconductor devices may be arranged so that the distance between adjacent semiconductor devices is minimized. For example, semiconductor devices having a hexagonal shape may be arranged in a crossing pattern to form a honeycomb structure in order to satisfy the above requirements.

The semiconductor devices of the present invention may satisfy all or any one of the above requirements.

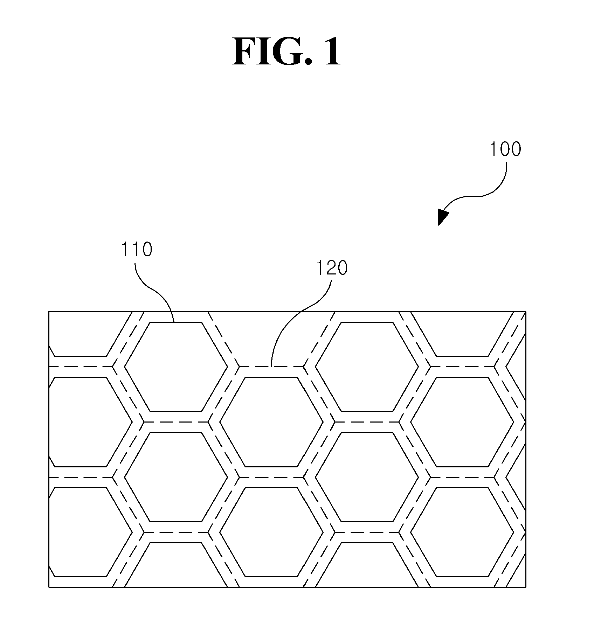

FIG. 1 is a top view showing a plurality of semiconductor devices according to an embodiment of the present invention. As shown therein, individual semiconductor devices 110 are arranged on a wafer 100. The spacing between the semiconductor devices 110 will hereinafter be referred to as a grid line 120.

The semiconductor device 110 may have any shape that can be patterned. This is because the semiconductor devices 110 are separated from each other by a selective etching or selective deposition (plating) method using a pattern, in place of the prior scribing or dicing technique.

The semiconductor devices 110 and the grid lines 120 may have a periodically repeating shape, because they are formed by patterning. In some embodiments, the shape of the semiconductor devices 110 and the grid lines 120 can be modified so that the length of the grid lines 120 versus the area of the semiconductor devices 110 is minimized.

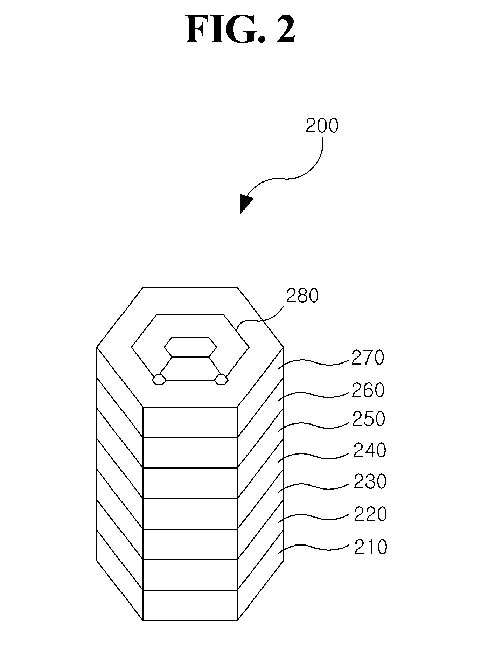

FIG. 2 shows a semiconductor device according to an embodiment of the present invention. As shown therein, the semiconductor device 200 comprises a metal layer 210, a first adhesive layer 220, a second adhesive layer 230, a first semiconductor layer 240, a light-emitting layer 250, a second semiconductor layer 260, a transparent electrode layer 270, and an electrode layer 280.

The first semiconductor layer 240 may be a P-type semiconductor layer, and a second semiconductor layer 260 may be an N-type semiconductor layer. The light-emitting layer 250 is interposed between the first semiconductor layer 240 and the second semiconductor layer 260 in order to increase the light-emitting efficiency of the light-emitting diode semiconductor device, and is also called a multi-quantum well (MQW) layer.

In some embodiments, the positions of the P-type semiconductor layer and the N-type semiconductor layer may be changed with each other. The first semiconductor layer 240, the light-emitting layer 250 and the second semiconductor layer 260 may be formed of a material comprising at least one of GaN, AlGaN, AlGaAs, AlGaInP, GaAsP, GaP and InGaN.

The metal layer 210 functions to supply a current to the first semiconductor layer 240 and support the semiconductor device 200. The metal layer 210 may be formed of a metal that has high electrical conductivity and thermal conductivity and relatively high mechanical strength, such as copper or a copper compound.

The metal layer 210 may be formed by an electrical plating method. In some embodiments, the metal layer 210 may consist of two layers, including a soft copper layer (not shown) which has low density and can relieve stress, and a hard copper layer (not shown) which has high density and strength and provides a mechanical support.

The first adhesive layer 220 comes into a direct contact with the metal layer 210 and forms a portion of the electrical path between the first semiconductor layer 240 and the metal layer 210. The second adhesive layer 230 also forms a portion of the electrical path between the first semiconductor layer 240 and the metal layer 210 and comes into direct contact with the first semiconductor layer 240.

In the fabrication process, the second adhesive layer 230, first adhesive layer 220 and the metal layer 210 may be sequentially formed on the first semiconductor layer 240. In this case, the second adhesive layer 230 can function to allow the first adhesive layer 220 to be smoothly bonded to the first adhesive layer 220 and may be formed of a compound comprising at least one of Ag, ITO, Ni, Pt, Pd and Au.

The first adhesive layer 220 functions as an intermediate layer between the metal layer 210 and the second adhesive layer 230 and may comprise, for example, Au.

The transparent electrode layer 270 may be formed of N-type indium tin oxide (ITO). The electrode layer 280 may comprise a metal and a metal compound and can function to promote the diffusion of an electric current to the surface of the second semiconductor layer 260.

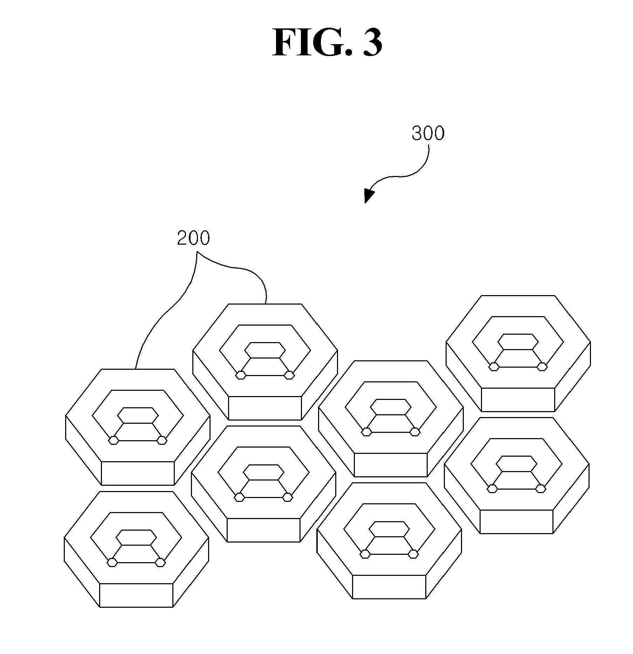

FIG. 3 shows an embodiment in which the semiconductor devices 200 of FIG. 2 are periodically arranged. The semiconductor devices 200 may be periodically spaced apart from each other.

In the embodiment of FIG. 3, each of the semiconductor devices 200 has a light-emitting side surface having a hexagonal shape and has a hexagonal columnar shape. In addition, in order to the spacing between the semiconductor devices 200 and increase the number of semiconductor devices 200 formed on the same wafer, the semiconductor devices 200 may be arranged in a crossing pattern to form a honeycomb structure.

In the prior dicing or scribing technique, chips were separated from each other by a physical force, and thus the grid line was necessarily a straight line. However, the semiconductor devices 200 of the present invention are easily separated from each other, because the metal layer 210 may be selectively etched (chemical etching or dry etching using a pattern) or selectively plated (only a portion of the metal layer 210 is previously formed using a pattern). Thus, the grid line does not need to be a straight line and may have any shape which can be periodically patterned.

When the semiconductor devices 200 have a hexagonal shape as shown in FIG. 3, the grid line (or street line) versus the area of the light-emitting side of the semiconductor devices 200 can be minimized, and thus the light-emitting efficiency can be increased. Because the edge line between the chips is reduced, electron-hole recombination and leakage current on the surface can be reduced, and thus the light-emitting efficiency versus the current applied can be increased. In addition, current spreading near the boundary between the light-emitting side surfaces of the semiconductor devices 200 can be increased, and thus high-power light-emitting diodes can be realized.

Hexagonal structures as shown in FIGS. 2 and 3 make it possible to further increase light extraction efficiency after packaging. Generally, a lens that transfers light has almost a circular shape, and a light-emitting diode having a hexagonal shape is more similar to a circular shape than one having a square shape, and thus can transfer a larger amount of light to the circular lens. Thus, when the hexagonal semiconductor devices 200 are packaged and coupled to the circular lenses, the light extraction efficiency can further be increased.

Because the semiconductor devices 200 may have any shape in a regular and periodical pattern, having a polygonal shape similar to a circular shape can increase the light extraction efficiency and the light-emitting efficiency versus the current applied.

However, in order to increase the number of the semiconductor devices 200 versus the same wafer area and minimize the area per chip, the semiconductor devices 200 may be arranged in a crossing pattern to form a honeycomb structure. The honeycomb structure is consistent with the crystal structure of the (0001) plane (c-plane) of a GaN-based semiconductor, and thus has an advantage in that the occurrence of defects during chip separation can be minimized.

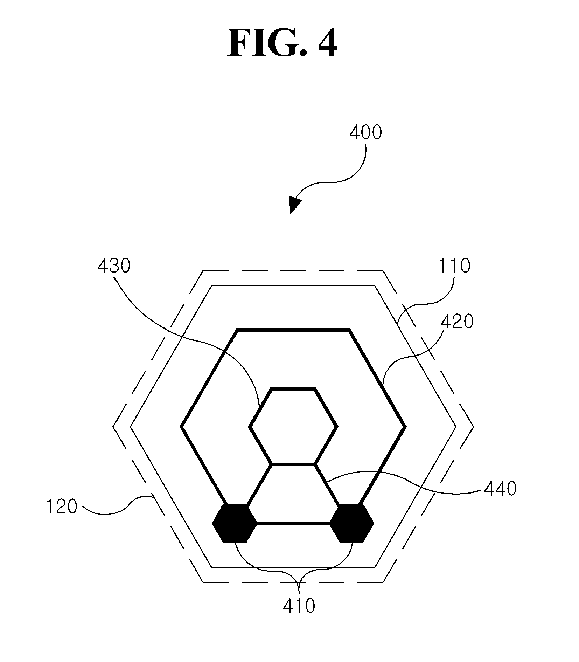

FIGS. 4 to 6 show various embodiments of the electrode structure of the semiconductor device 110 shown in FIG. 1.

As shown in FIG. 4, the semiconductor device 110 comprises electrodes 410, an outer finger connected to the electrode, an inner finger 430 spaced apart from the outer finger 420, and connection fingers 440 that connect the electrode 410, the outer finger 420 and the inner finger 430 to each other. The electrode 410, the outer finger 420, the inner finger 430 and the connection finger 440 correspond to the electrode layer 280 shown in FIG. 2.

The electrode 410 is a portion through which voltage can be applied to the semiconductor device 110 from the outside using a wiring method such as wire bonding. The outer finger 420 is connected to the electrode 410 so that voltage can be effectively transferred even to the border of the surface of the semiconductor device 110. The inner finger 430 is connected to the electrode 410 or the outer finger 420 by the connection finger 440 so that voltage can be effectively applied even to the central portion of the semiconductor device 110. It may be designed such that the distance of the electrode 410 or the fingers 420, 430 and 440 from any point of the surface of the semiconductor device 110 is, for example, 1/2 of or less than the distance between the outer finger 420 and the inner finger 430. When the electrode layer 280 is formed of a light-reflecting material (opaque material), there is a disadvantage in that, if the area of the electrode layer 280 increases, the amount of light emitted from the semiconductor device 400 decreases. When the electrode 410 and the fingers 420, 430 and 440 connected to the electrode 410 are used, voltage can be smoothly applied to the surface of the semiconductor device 100 while the area of the electrode layer 280 can be reduced. In the structure shown in FIG. 4, the electrode 410 is disposed at the two adjacent corners of the hexagonal outer finger 420, and the outer finger 420 and the inner finger 430 have a hollow hexagonal shape. The connection fingers 440 connect the two corners of the outer finger 420 to the corners of the inner finger 430, which are closest to the outer finger 420.

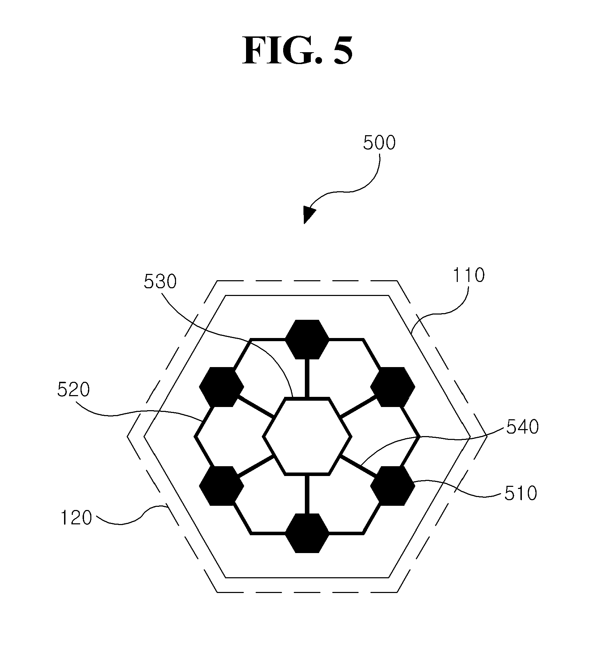

FIG. 5 illustrates the size and location of electrodes and fingers in a semiconductor device 500 according to another embodiment of the present invention. In the same manner, the semiconductor device comprises electrodes 510 to which voltage can be applied from the outside, an outer finger 520 which is connected to the electrodes 510 so that voltage can be smoothly applied to the border of the surface of the semiconductor 110, an inner finger 530 allowing voltage to be smoothly applied to the central portion of the surface of the semiconductor device 110, and connection fingers 540 that connect the electrodes to the inner fingers 530. In the structure shown in FIG. 5, the outside finger 520 and the inner finger 530 have a hollow hexagonal shape, and the electrodes 510 are disposed between all the adjacent corners of the hexagonal outer finger 520. The connection finger 540 connects each electrode 510 to one point of the inner finger 530, that is, a point which is closest to each respective electrode.

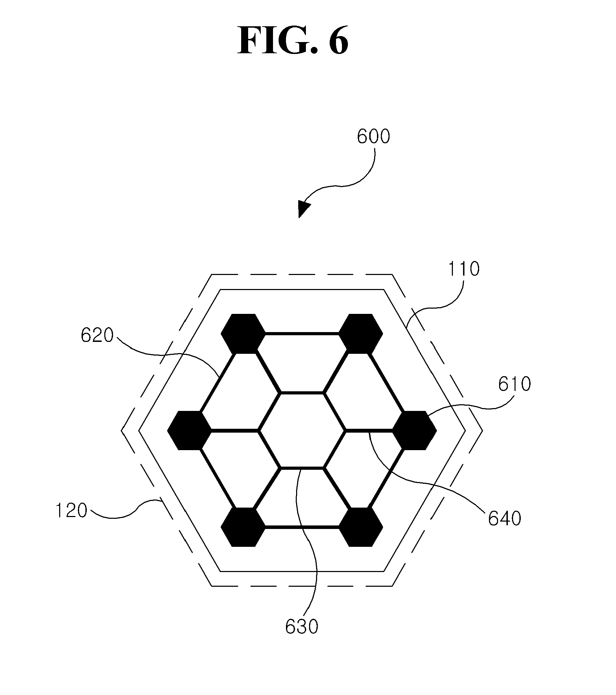

FIG. 6 illustrates the size and location of electrodes and fingers in a semiconductor device 600 according to another embodiment of the present invention. In the structure shown in FIG. 6, the outside finger 620 and the inner finger 630 have a hollow hexagonal shape, and the electrodes 610 are disposed at all the corners of the hexagonal outer finger 620. Each of the connection fingers 640 connects each electrode 610 to one point of the inner finger 630, that is, a point which is closest to each respective electrode 610.

In the structures illustrated in FIGS. 4 to 6, the electrodes and the fingers are made of a conductive material, and thus voltage is applied to the fingers almost simultaneously with the application of voltage to the electrodes. Because voltage is transferred uniformly to the whole region of the surface of the semiconductor device 110, an electrical current diffuses rapidly to the whole region of the surface of the semiconductor device 110.

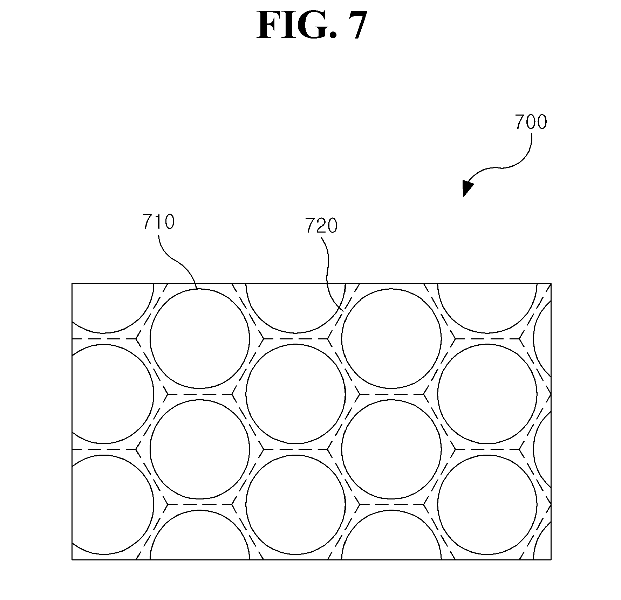

FIG. 7 is a top view showing a plurality of semiconductor devices according to another embodiment of the present invention. As shown therein, a wafer 700 comprises semiconductor devices 710 and a grid line 720. As described above, the shape of the semiconductor devices 710 of the present invention is not limited. The shape of the semiconductor devices 110 shown in FIG. 1 is hexagonal, but the shape of the semiconductor devices 710 shown in FIG. 7 is circular.

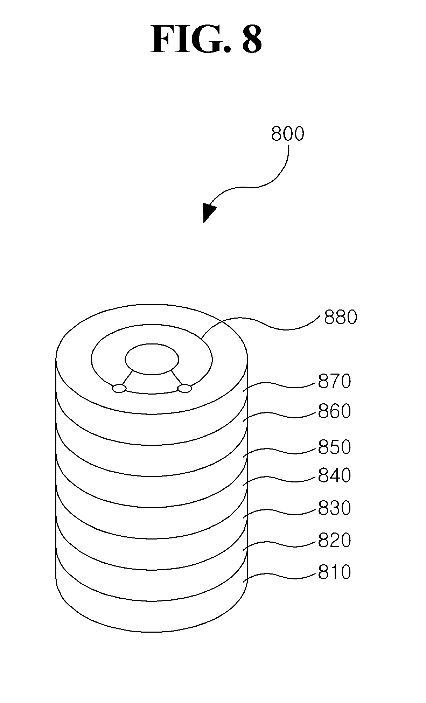

FIG. 8 shows a semiconductor device according to another embodiment of the present invention. As shown therein, the semiconductor device 800 comprises a metal layer 810, a first adhesive layer 820, a second adhesive layer 830, a first semiconductor layer 840, a light-emitting layer 850, a second semiconductor layer 860, a transparent electrode layer 870 and an electrode layer 880. The semiconductor device 200 shown in FIG. 2 and the semiconductor device 800 shown in FIG. 8 are structurally very similar to each other, except that these semiconductor devices have a hexagonal shape and a circular shape, respectively. Thus, the description of each element is omitted.

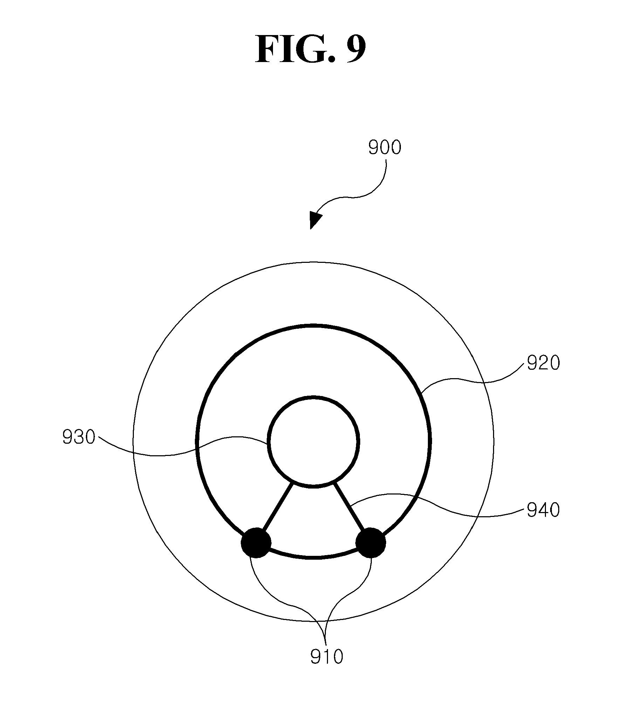

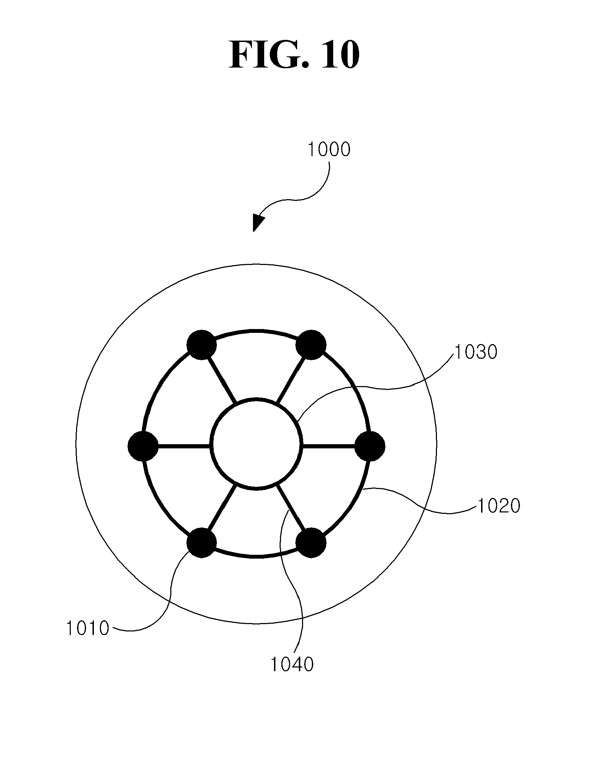

FIGS. 9 and 10 illustrate the sizes and positions of electrodes and fingers in the semiconductor device shown in FIG. 7.

As shown in FIG. 9, the semiconductor device 900 comprises electrodes 910, an outer finger 920 connected to the electrodes, an inner finger 930 spaced apart from the outer finger 920, and connection fingers 940 that connect the electrodes 910, the outer finger 920 and the inner finger 930 to each other. The electrodes 910, the outer finger 920, the inner finger 930 and the connection fingers 940 correspond to the electrode layer 880 shown in FIG. 8. The electrode 910 is a portion through which voltage can be applied to the semiconductor device 900 from the outside using wiring such as wire bonding. The outer finger 920 is connected to the electrode 910 so that voltage can be smoothly applied to the border of the surface of the semiconductor device 710. The inner finger 930 is connected to the electrode 910 or the outer finger 930 by the connection finger 940 so that voltage can also be applied to the central portion of the surface of the semiconductor device 710.

In the structure shown in FIG. 9, the outer finger 920 and the inner finger 930 have a hollow circular shape, and the electrodes 910 are disposed at any two points of the circular outside finger 920. Each connection finger 940 connects each electrode 910 to one point of the inner finger 930, that is, a point which is closest to each respective electrode 910.

FIG. 10 illustrates the sizes and positions of electrodes and fingers in a semiconductor device 1000 according to another embodiment of the present invention. In the structure illustrated in FIG. 10, the outer finger 1020 and the inner finger 1030 have a hollow circular shape, and the electrodes 1010 are formed along the circumference of the outer finger 1020 and are arranged at intervals of 60°. Each of the connection fingers 1040 connects each electrode 1010 to one point of the inner finger 1030, that is, a point which is closest to each respective electrode 1010. The electrode electrodes shown in FIGS. 9 and 10 have the effects of reducing the area of the opaque electrode layer 880 so as to minimize the interference of light progression by the electrode layer 880, and applying voltage uniformly to the whole region of the surface of the semiconductor device 710 and also diffusing an electric current to the whole region ofthe surface.

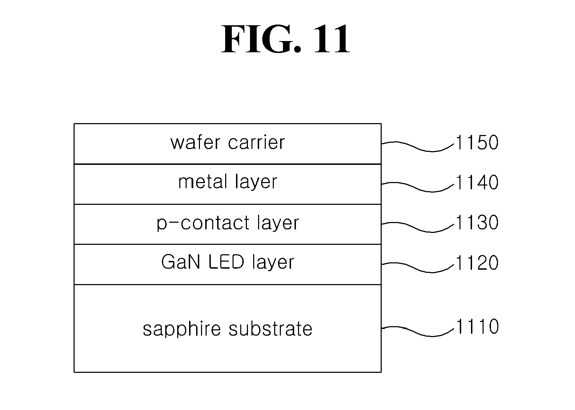

FIGS. 11 to 13 are process diagrams showing a first embodiment of a method for manufacturing semiconductor devices according to the present invention. As shown in FIG. 11, a light-emitting diode layer 1120 and a P-type first contact layer 1130 are formed on a substrate 1110. The light-emitting diode layer 1120 may comprise an N-type semiconductor layer, a P-type semiconductor layer and a light-emitting layer. After forming the semiconductor layers 1120 and 1130, a first metal layer 1140 is formed. For smooth bonding between the first contact layer 1130 and the first contact layer 1140, an adhesive layer may further be formed between the first contact layer 1130 and the first contact layer 1140. The metal layer 1140 may be formed of a material that has high electrical conductivity and thermal conductivity and can provide a mechanical support. For example, it may be formed of a material such as copper.

After depositing the first metal layer 1140, a wafer carrier 1150 is formed on the first metal layer 1140. For example, the wafer carrier may be formed of a perforated wafer carrier or a compound comprising at least one of a semiconductor, a semiconductor compound and a metal oxide. For smooth bonding, an adhesive layer may also be formed between the first metal layer 1140 and the wafer carrier 1150. Examples of the compound include Si, GaN, Al₂O₃ (sapphire), Si-C (silicon carbide), or combinations thereof.

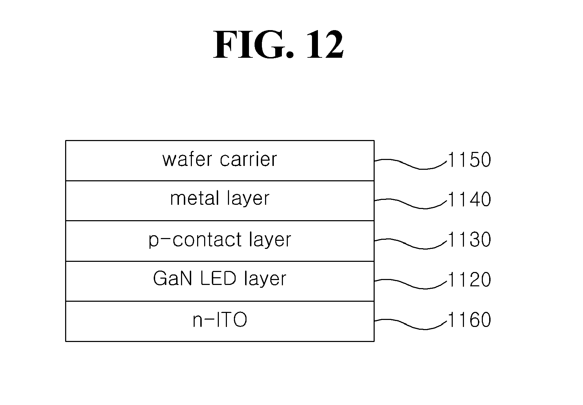

As shown in FIG. 12, the substrate 1110 and the light-emitting diode layer 1120 are separated from each other. When the substrate 1110 is irradiated with a laser having a specific frequency, which can pass through the substrate 1110, the laser that passed through the substrate 1110 is absorbed into the boundary between the substrate 1110 and the light-emitting diode layer 1120 to generate heat. At this time, the boundary between the substrate 1110 and the light-emitting diode layer 1120 is melted so that the substrate 1110 is separated from the light-emitting diode layer 1120. This process of separating the substrate 1110 using the laser is also called laser lift off (LLO). The light-emitting diode layer 1120 separated from the substrate 1110 is supported by the metal layer 1140 and the wafer carrier 1150.

The process of separating the substrate 1110 from the light-emitting diode layer 1120 may also be performed by chemical lift off (CLF). The CLO process is performed by a chemical reaction at the boundary between the substrate 1110 and the light-emitting diode layer 1120.

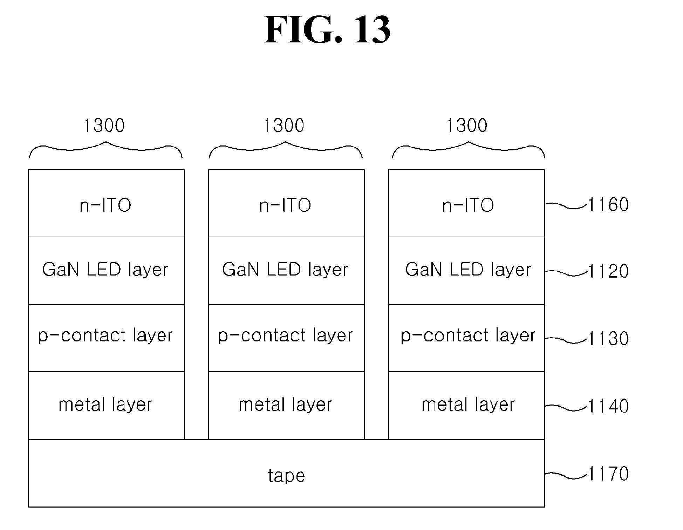

After separating the substrate 1110 from the light-emitting diode layer 1120, a transparent electrode layer 1160 may be formed. The transparent electrode layer 1160 may be formed of an N-type indium tin oxide. Although not shown in FIGS. 12 and 13, an electrode layer adjacent to the transparent electrode layer 1160 may further be formed after forming the transparent electrode layer 1160.

As shown in FIG. 13, in order to fabricate individual semiconductor devices 1300, the transparent electrode layer 1160, the light emitting layer 1120 and the first contact layer 1130 are etched according to a predetermined pattern. Herein, the process of etching the transparent electrode layer 1160, the light emitting layer 1120 and the first contact layer 1130 is performed according to predetermined mask patterns as shown in FIGS. 1 to 10. Specifically, a mask pattern is formed on "device regions" in which the individual semiconductor devices 1300 are to be formed, and a surface corresponding to the boundary between the device regions is exposed. As the etching process is performed, the boundary region of the transparent electrode layer 1160, the light-emitting layer1120 and the first contact layer 1130 is removed, and thus the process of separating the adjacent individual semiconductor devices 1300 from each other is partially performed.

The wafer carrier 1150 can be removed from the metal layer 1140, after the process of etching the transparent electrode layer 1160, the light-emitting layer 1120 and the first contact layer 1130 was performed. Herein, before the process of etching and separating the metal layer 1140, a support tape (not shown) may be adhered to the transparent electrode layer 1160.

After the water carrier 1150 is removed, a mask pattern is deposited on the device regions of the metal layer 1140, and the boundary region is exposed. Then, a dry etching or wet etching process is applied to the metal layer 1140 so that the metal layer 1140 in the boundary region is etched.

After completion of the process of etching the metal layer 1140 in the boundary region, the deposited mask pattern is removed. After removing the mask pattern, the metal layer 1140 is adhered to a support tape 1170 by a transfer process.

FIG. 13 shows a state in which the etching process was completed. As shown therein, the individual semiconductor devices 1300 are separated from each other by the process of etching the metal layer 1140. The individual semiconductor devices 1300 comprise the metal layer 1140, the first contact layer 1130, the light emitting diode layer 1120, and the transparent electrode layer 1160. Thus, the cross-section of the individual semiconductor devices 1300 is as shown in FIG. 13, and the surface of the individual semiconductor devices 1300 may have various shapes, including circular and polygonal shapes.

Herein, because the metal layer 1140 is separated into regions so that it cannot function as a connection support layer, the support tape 1170 temporarily functions to connect and support the individual semiconductor devices 1300. Each of the individual semiconductor devices 1300 is separated from the support tape 1170 and subjected to a packaging process, thereby providing an individual chip.

In the prior art, when the metal layer 1140 was selected as the connection support layer, the process of etching it was not smoothly performed. For this reason, the dicing or scribing technique was widely used to separate the connection support layer.

In the dicing or scribing process, a material such as silicon carbide (Si-C) is used as a connection support layer, a plurality of semiconductor devices cannot be separated, and only one semiconductor device can be separated at a time. Thus, the separation process in the prior art is a process, which is most time-consuming and likely to fail, in processes for manufacturing light-emitting diodes.

In the prior art, even when a metal material such as copper, which has high electrical conductivity and thermal conductivity to show high ability to transfer an electric current, was to be used as the connection support layer, the dicing or scribing technique was difficult to apply, because the copper layer has high ductility. Thus, the scribing technique was performed using a material having low electrical conductivity, such as molybdenum, in place of copper.

In the first embodiment of the inventive method for manufacturing the semiconductor devices, only a portion (boundary region excluding device regions) of the metal layer 1140 is exposed, it can be etched using at least one of copper II chloride (CuCl₂), hydrochloride (HCl) and hydrogen peroxide (H₂O₂).

Herein, because only the boundary region excluding the device regions is exposed so that the etching solution is concentrated on a portion of the metal layer 1140, which is to be etched, the etching of copper can be promoted, and the concentration of the solution, the line width of the exposed boundary region, etc., can be determined through experiments.

As described above, as the etching of the metal layer 1140, which was impossible in the prior art, becomes possible, a plurality of semiconductor devices 1300 can be separated at the same time, and thus the time required for the separation process can be greatly reduced. In addition, no physical impact is applied in the separation process, unlike the dicing or scribing process, and thus the yield of the separation process is greatly improved.

Moreover, the etching of the metal layer 1140 can be performed using dry etching in addition to wet etching. When the metal layer 1140 is a copper layer, it can be dry-etched using dry etching methods, including a laser-based method, ICP, ion milling, RIE, sputter etching, ion beam assisted etching and the like. For example, chips corresponding to the semiconductor devices 1300 can be separated by etching the metal layer 1140 using chlorine plasma.

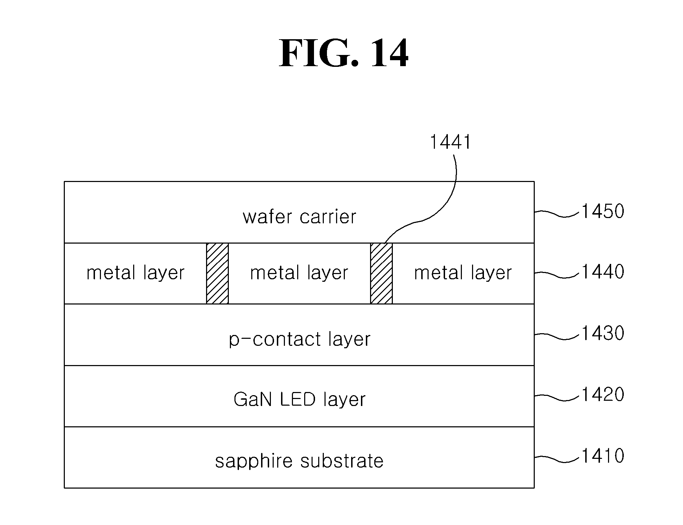

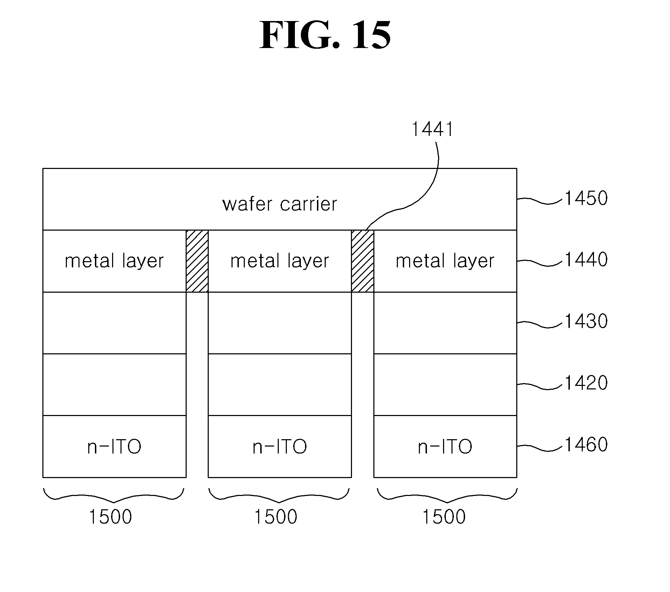

FIGS. 14 and 15 are process diagrams showing a second embodiment of the inventive method for manufacturing semiconductor devices.

As shown in FIG. 14, a light-emitting diode layer 1420 and a P type first contact layer 1430 are formed on a substrate 1410. After forming the semiconductor structure layers 1420 and 1430, a mask layer 1441 is formed. A first metal layer 1440 is formed on the exposed portion of the semiconductor structure layers 1420 and 1430, on which the mask layer 1441 was not deposited.

Specifically, the first mask pattern is constructed so as to cover the device regions, in which the light-emitting diode devices are to be formed, and open the boundary region excluding the device regions. Because only the boundary region of the contact layer 1430 is exposed by the first mask pattern, the mask layer 1441 is deposited on the boundary region.

As opposed to the first mask pattern, a second mask pattern is constructed so as to open the device regions and cover the boundary region. The process for forming the first metal layer 1440 is performed using the second mask pattern. Herein, the previously formed mask layer 1441 may also naturally act as the second mask pattern. For example, when the first metal layer 1440 is formed by plating, if the mask layer 1441 is a non-conductive material (e.g., photoresist), the mask layer will not be plated, because no current passes therethrough. The exposed device regions of the contact layer 1430, on which the mask layer 1441 is not formed, are plated with the first metal layer 1440, because an electric current passes therethrough.

After forming the mask layer 1441 and the first metal layer 1440, a wafer carrier 1450 is adhered onto the mask layer 1441 and the first metal layer 1140. Like the case of FIGS. 12 and 13, the wafer carrier 1450 supports the semiconductor structure layers 1420 and 1430 and the first metal layer 1440.

As shown in FIG. 15, the light-emitting diode 1420 is separated from the substrate 1410. The separation process can be performed using the laser lift off process described above, and thus the description thereof is omitted. On the exposed surface of the separated light-emitting diode layer 1420, a transparent electrode layer 1460 is formed, and an electrode layer (not shown) for applying voltage to the individual semiconductor devices 1500 may further be formed. After forming the transparent electrode layer 1460 and the electrode layer, the transparent electrode layer 1460, the light emitting diode 1420 and the first contact layer 1430 are patterned and etched in order to separate each semiconductor device 1500 in a desired shape. Because the first mask pattern used to form the mask layer 1441 covers the device regions and opens the boundary region, the etching of the light-emitting diode layer 1420, the first contact layer 1430 and the transparent electrode layer may be performed using the first mask pattern.

The individual semiconductor devices 1500 are separated from each other by the etching process. After the separation process, the individual semiconductor devices 1500 are maintained in a connected state and supported by the wafer carrier 1450. As the wafer carrier 1450 is removed, the process for manufacturing the individual semiconductor devices 1500 is completed.

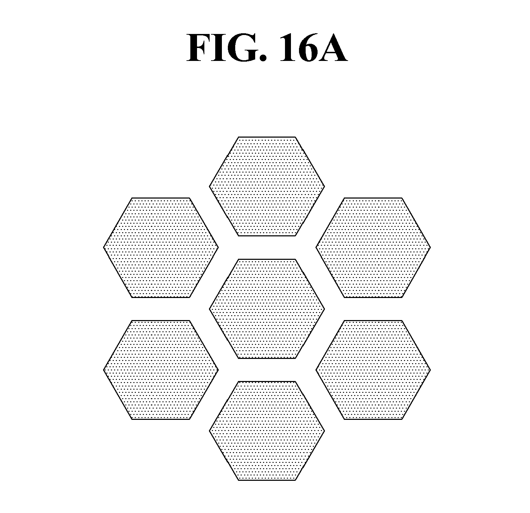

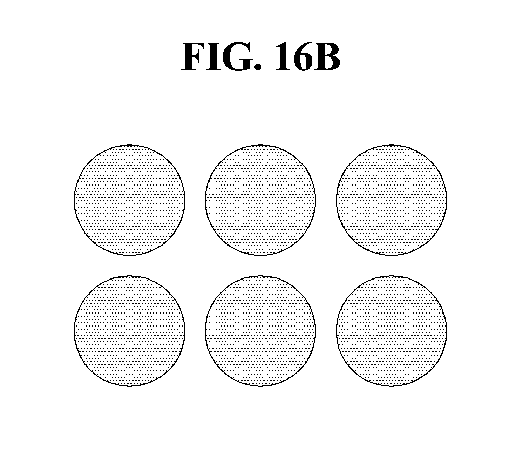

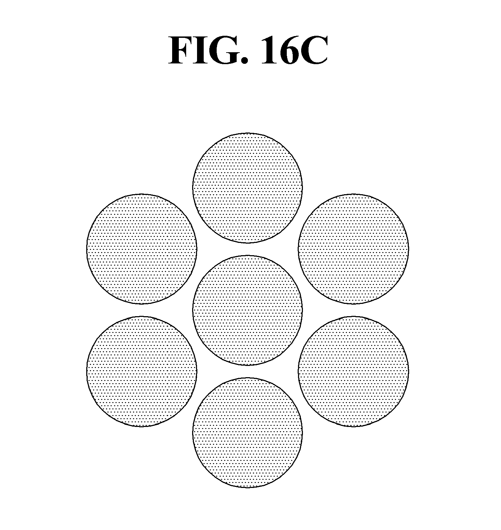

FIG. 16 shows various examples of the first mask pattern shown in FIGS. 14 and 15. The first mask pattern may also be used in the etching process for separating the individual semiconductor devices 1300 as shown in FIG. 13.

In the mask patterns shown in FIG. 16, the ash color portions are portions are portions of an object, which are covered by a mask, and the white portion is an exposed portion of the object, on which the mask is not formed. The exposed region of the object is etched, or the mask layer 1441 is deposited thereon. FIGS. 16(a), 16(b) and 16(c) show various examples of the mask pattern for etching, and when etching is performed to leave only the portions on which the mask was formed, semiconductor devices can be fabricated as columns having any shape (polygon, circle, etc.) which can be embodied by the mask.

In FIG. 16, the gray color regions are the device regions, and the white region is the boundary region. The width of the boundary region shown in FIG. 16 is exaggerated for the convenience of explanation, but it is obvious to those skilled in the art that the width of the boundary region is not the essence of the present invention, but is the concomitant of the present invention.

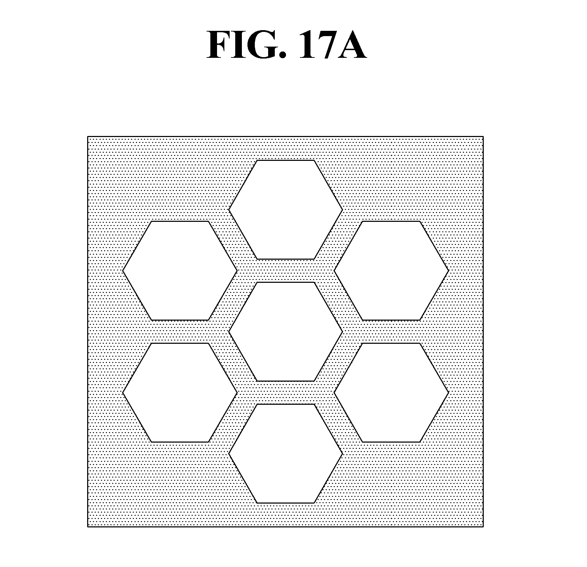

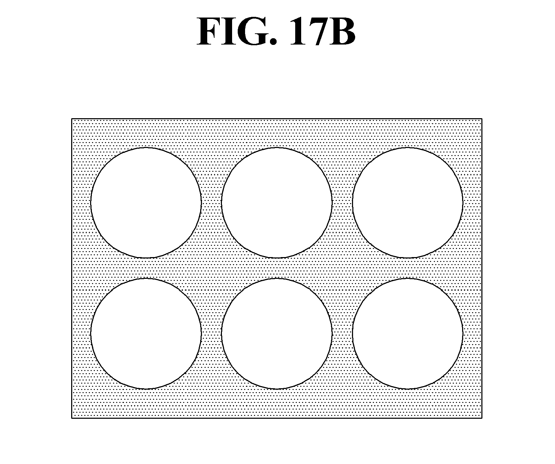

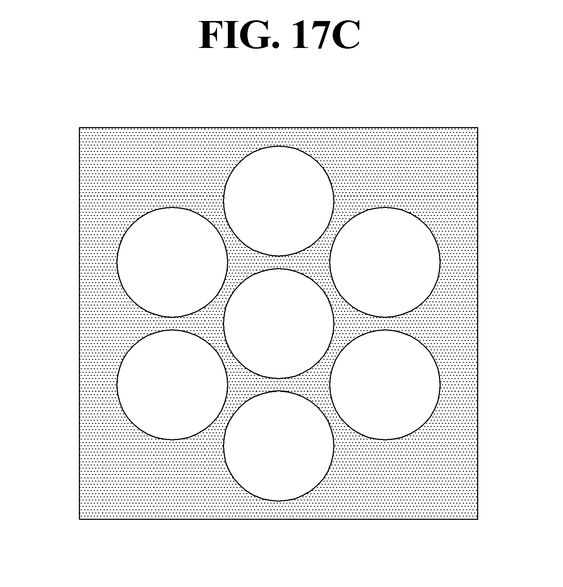

FIG. 17 shows various examples of the second mask pattern shown in FIGS. 14 and 15. The second mask pattern is used for the selective deposition of the metal layer 1440, and the previously formed mask layer 1441 may naturally function as the mask pattern in FIG. 17. The ash color region is a region covering an object, and the white regions are regions through the object is exposed. In FIG. 17, the ash color region is the boundary region, and the white regions are the device regions.

According to another embodiment of the present invention, the mask patterns shown in FIGS. 16 and 17 can be modified and applied as follows. When the substrate is separated from the light-emitting diode layer by the LLO process, the individual semiconductor devices can be separated simultaneously by suitably controlling the size of the laser beam spot.

When the laser beam spot covers each of the circles or polygons shown in FIGS. 16 and 17, the LLO process is performed for each individual semiconductor device. Meanwhile, when the laser beam spot is sufficiently large such that it covers all the circles or polygons shown in FIGS. 16 and 17, a plurality of individual semiconductor devices can be simultaneously subjected to the LLO process, and thus the time required for the LLO process can be reduced. The reason why the time of the LLO process can be reduced as described above is that the individual semiconductor devices of the present invention are regularly and periodically arranged. For example, referring to FIGS. 16(a) and 17(a), when the laser beam spot covers 7 hexagonal patterns, 7 individual semiconductor devices can be simultaneously subjected to the LLO process, the time ofthe LLO process can be reduced 7 times.

According to another embodiment of the present invention, there is provided a means capable of controlling the area of semiconductor devices which are separated into individual chips. Referring to the mask patterns shown in FIGS. 16 and 17, after the individual semiconductor devices have been formed in a circular or polygonal shape, one or more semiconductor devices can be grouped into one group by controlling the mask during the process of separating the individual semiconductor devices from each other. The individual semiconductor device or devices grouped into one group may be packaged as one individual chip.

Specifically, using the mask patterns shown in FIGS. 16 and 17, individual semiconductor devices having a circular or polygonal shape are formed. When the mask patterns shown in FIGS. 16 and 17 are used in the subsequent separation process, each individual semiconductor device is packaged as each individual chip. Meanwhile, when a plurality of circular or polygonal shapes are grouped into one group, only the boundary region between the groups can be etched, and the boundary region between the individual chips of the group cannot be etched. In this case, a plurality of individual semiconductor devices can be packaged as one individual chip. This separation process can be relatively easily realized by controlling the mask pattern.

For example, after individual semiconductor devices corresponding to the hexagonal patterns shown in FIG. 16(a) have been formed, when 7 hexagonal patterns are grouped into one group in the separation process, the 7 hexagonal patterns can form one large hexagonal device group.

In actual application, the requirement for the size of each light-emitting diode chip can be changed. In this case, in order to minimize the cost and time of fabrication of the final product, the size of light-emitting diode chips can be selectively controlled by forming individual semiconductor devices having a minimum unit size, and finally selecting the number of individual semiconductor devices in the separation step.

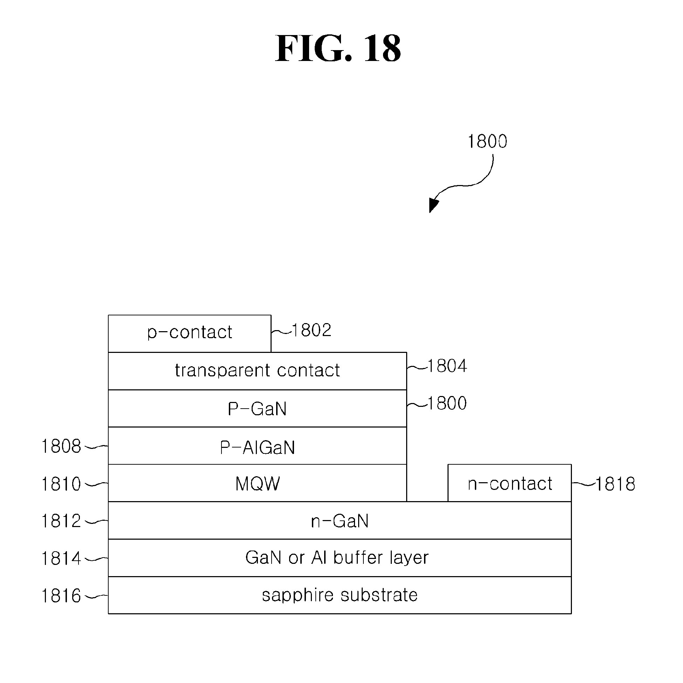

FIG. 18 is a cross-sectional view showing a semiconductor device according to another embodiment of the present invention. As shown therein, the semiconductor device 1800 comprises a substrate 1816, a first semiconductor layer 1808, a second semiconductor layer 1812, a light emitting layer 1810 located between the first semiconductor layer 1808 and the second semiconductor layer 1812, a buffer layer 1814 formed for smooth adhesion between the substrate 1816 and the second semiconductor layer 1812 and protection of the second semiconductor layer 1812, a first electrode layer 1802 and a transparent electrode layer 1804, which serve to apply voltage to the first semiconductor layer 1812, and a second electrode layer 1818 for smoothly applying voltage to the second semiconductor layer 1812. In the case of the semiconductor device 1800 having this configuration, a semiconductor device can be fabricated as a column having any shape (e.g., a polygonal or circular shape) by removing the sapphire substrate 1816 by the laser lift off process, forming a metal support layer (not shown) on the remaining structure, and etching the metal support layer by a dry or wet etching process using a predetermined pattern.

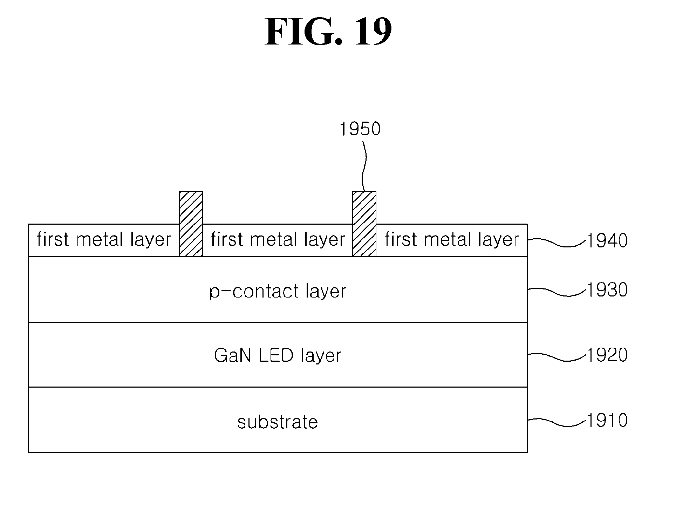

FIGS. 19 to 21 show a third embodiment of the inventive method for manufacturing semiconductor devices.

Referring to FIG. 19, a light-emitting diode layer 1920 is formed on a substrate 1910, and a p-type first contact layer 1930 is deposited on the light-emitting diode layer 1920.

On the boundary region excluding the device regions of the first contact layer 1930, a mask layer 1950 is deposited. Then, a first metal layer 1940 is deposited on the device regions of the first contact layer 1930.

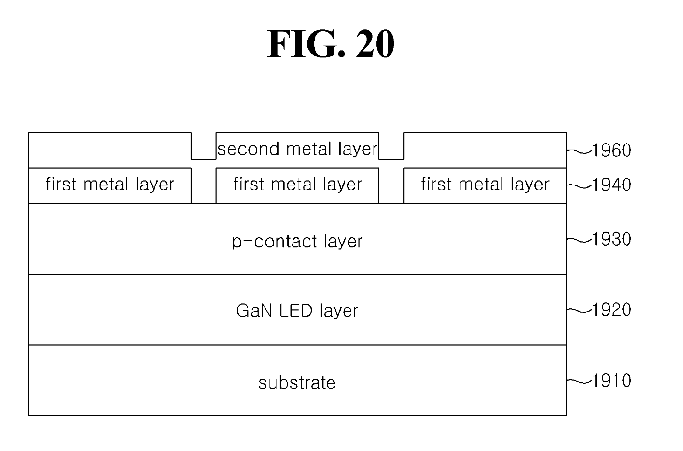

Referring to FIG. 20, after the first metal layer 1940 has been deposited to a predetermined thickness, the mask layer 1950 is removed. Then, a second metal layer 1960 is deposited on the whole region including the device regions and the boundary region.

Subsequent processes are partially similar to the processes shown in FIGS. 11 to 15. The substrate 1910 is separated from the light-emitting diode layer 1920 by the laser lift off (LLO) or chemical lift off (CLO) process. On the exposed surface of the light-emitting diode 1920, a transparent electrode layer 1970 may be formed.

The process for etching the transparent electrode layer 1970, the light-emitting diode layer 1920 and the first contact layer 1930 is a process for forming individual semiconductor devices. The boundary region is removed by etching so as to leave the device regions of the transparent electrode layer 1970, the light-emitting diode layer 1920 and the first contact layer 1930.

Then, before a process of separating the second metal layer 1960 into regions, a support tape 1980 is adhered to a surface opposite the second metal layer 1960, that is, the transparent electrode layer 1970, in order to connect and support individual semiconductor devices.

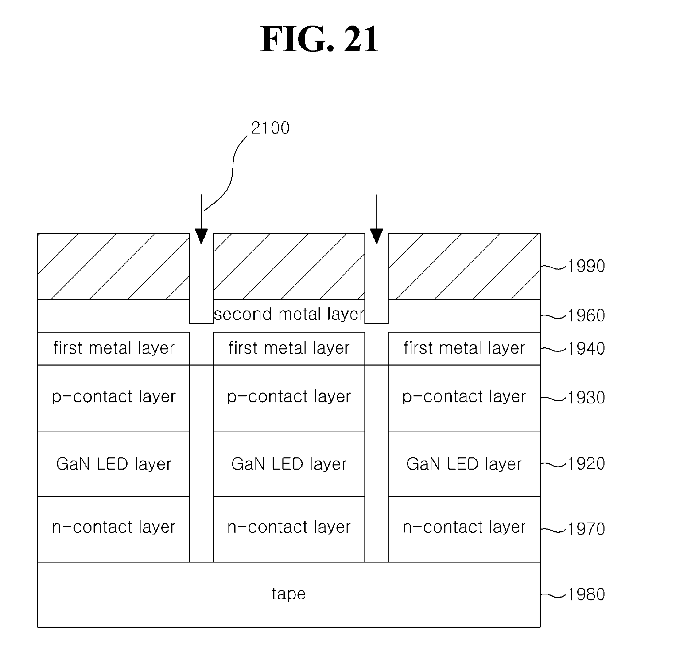

Referring to FIG. 21, a mask layer 1990 is deposited on the regions of the second metal layer 1960 that correspond to devices, and the exposed boundary region of the second metal layer 1960 is etched by an etchant 2100.

As described above, the etching process may be performed using a dry or wet etching method.

According to the third embodiment, the time required to etch the second metal layer 1960 can be optimized by controlling the thickness of the first metal layer 1940, which is formed on a portion of the surface, and the thickness of the second metal layer which is formed on the whole surface. In addition, whether the shape of the side after the process of etching the metal layers can be sufficiently controlled is one of factors to be considered. Because the second layer 1960 functions connects and supports individual semiconductor devices, the thickness of the second metal layer 1960 can be determined considering various factors, including the time required for the etching process, the shape of the side after etching, and the strength for structural support.

Individual semiconductor devices separated from each other are supported by the first metal layer 1940 and the second metal layer 1960, and thus can be more stably supported.

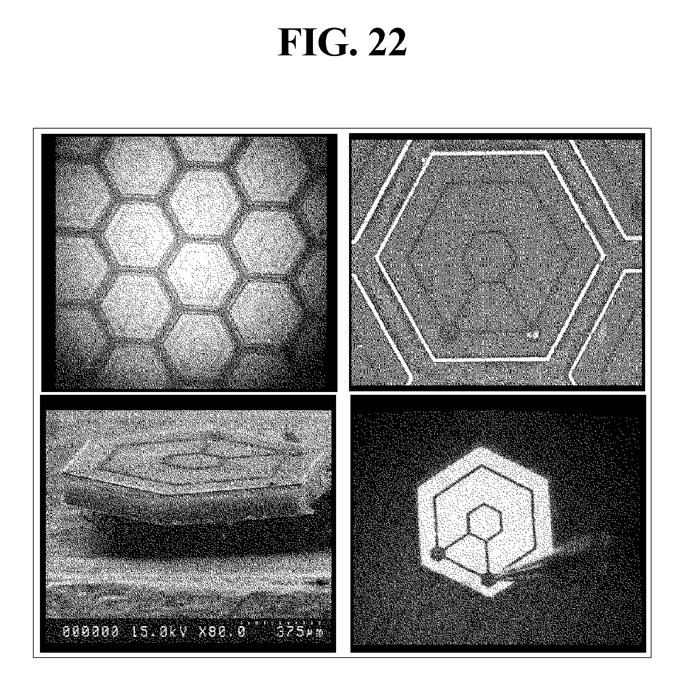

FIG. 22 shows semiconductor devices arranged in a honeycomb structure according to an embodiment of the present invention.

Referring to FIG. 22, a fabricated sample of light-emitting diodes, having the electrode structure of FIG. 4 and arranged in a honeycomb structure, is shown. The SEM (scanning electron microscope) microscope of FIG. 23 shows an enlarged view of hexagonal column-shaped light-emitting diodes separated into individual chips. FIG. 22 also shows that light-emitting diodes separated into individual chips emit light upon application of voltage.

FIG. 22 clearly shows the distinction of the present invention from the prior art. According to the present invention, unlike the prior art, individual light-emitting diode devices having a hexagonal columnar shape can be obtained in high yield, and damage to the device in the separation process can be minimized. The present invention may be applied to a circular shape and any polygonal shape such as a hexagonal shape, which can be realized by a mask pattern. In addition, according to the present invention, individual light-emitting diode devices can be separated from each other, even when the grid line is not a straight line as shown in FIG. 22.

The methods for manufacturing semiconductor devices according to the embodiments of the present invention may be implemented in the form of program commands executable by various kinds of computers and recorded in a computer-readable recording medium.

Also, the methods may be provided in the form of software/firmware programmed in the memory of a controller that generates signals for controlling semiconductor device fabrication systems, and these methods can be sequentially performed according to the programmed order.

The computer-readable recording medium may include program commands, data files, data structures or the like, either separately or in combination. The program commands recorded on the medium may be specially designed and configured for the present disclosure or be known to and used by those skilled in the computer software fields. The recording medium includes, for example, magnetic media such as hard disks, floppy disks and magnetic tapes, optical media such as CD-ROM and DVD, magneto-optical media such as floptical disks, and hardware units such as ROM, RAM and flash memories, which are specially configured to store and perform program commands. The program command includes, for example, machine language codes composed by a compiler and high-level language codes executable by a computer by using an interpreter or the like. The hardware unit may be configured to operate as at least one software module in order to perform operations of the present disclosure, or vice versa.

According to the inventive method for manufacturing a semiconductor device, individual devices are separated from each other by a process of selectively forming a metal layer using a pattern or selectively dry/wet etching a metal layer using a pattern, in place of a process of separating individual devices from each other using the prior dicing or scribing process, and thus individual light-emitting diode devices can be prepared in any shape.

In the prior dicing or scribing process, individual devices were separated from each other by a physical force, and thus a boundary region between the individual devices may necessarily be a straight line. However, in the inventive method for manufacturing semiconductor devices, individual devices can be easily separated from each other, even when a boundary region therebetween has any pattern.

Specifically, a method of forming a mask, forming a metal layer only on a region other than the mask and etching a portion of a semiconductor structure layer, which corresponds to the mask, is used, a semiconductor device having a polygonal columnar or circular columnar shape can be fabricated, because the mask pattern is not limited to a straight line.

Further, according to the present invention, because a semiconductor device can be fabricated in a polygonal columnar or circular columnar shape, the street line versus the area of the semiconductor device can be reduced, and thus the semiconductor device can have increased light-emitting efficiency.

The semiconductor device can be formed in a hexagonal shape or any polygonal shape, which are more similar in shape to a commonly used circular lens than a rectangular shape. Thus, the light extraction efficiency of the light-emitting diode can be increased.

In addition, the semiconductor device according to the present invention may have an optimized electrode structure on the surface of the light-emitting side having any polygonal shape or a circular shape. In the electrode structure of the present invention, the distance of the conductive finger electrode from any point of the surface of the light-emitting side of the semiconductor device may be a specific value or less. When voltage is applied to the electrode, the same voltage is instantaneously applied between the conductive finger and the electrode, and an electric current is diffused from the finger or the electrode to the surface of the semiconductor device. Thus, the electrode structure of the present invention allows an electric current to be rapidly diffused on the surface of the light-emitting side of the semiconductor device.

Although the inventive method for manufacturing the semiconductor device has been described with respect to the fabrication of the vertical-type semiconductor device, but the fundamental sprit of the present invention can also be applied to horizontal-type semiconductor devices. In addition, in the inventive method for manufacturing the semiconductor device, the semiconductor devices can be individually separated from the substrate, and a plurality of the semiconductor devices can be separated from the substrate at the same time by controlling the size of the beam spot in a laser lift off (LLO) process. For example, in the case of hexagonal honeycomb structures, hexagonal structures can be individually separated, and 7 hexagonal structures can also be separated at the same time by controlling the beam spot size.

In addition, according to the inventive method for manufacturing the semiconductor device, after individual semiconductor device regions have been formed, a group including one or more individual semiconductor device regions can be separated as one individual semiconductor device by patterning. For example, in the above-described honeycomb structure, one hexagonal structure can be separated as an individual semiconductor device, and when a chip having a larger size is required, a group including 7 hexagonal structures can also be separated as one individual chip.

As described above, the present invention relates to a semiconductor device capable of emitting light upon application of voltage and a method for manufacturing the same, and more particularly to a semiconductor device having a polygonal or circular columnar shape and a a method for manufacturing the same.

The semiconductor device of the present invention comprises a plurality of semiconductor structures and a connecting support layer that supports the plurality of semiconductor structures, wherein each of the plurality of semiconductor structures comprises a P-type first semiconductor layer, an N-type second semiconductor layer, and a light-emitting layer located between the first semiconductor layer and the second semiconductor layer, and forms a polygonal or circular column.

As described above, although the present invention has been presented based on specific limitations such as detailed components as well as limited embodiments and drawings, they are provided just for better understanding of the present disclosure, and the present disclosure is not limited to the embodiments and may be changed or modified in various ways by those having ordinary skill in the art. Therefore, the spirit of the present invention should not be limited to the above embodiments, and the appended claims and all equivalents or equivalent modifications thereof should be recognized as being included in the scope of the present invention.

## Claims

1. A semiconductor device comprising:
a plurality of semiconductor structures; and
a connection support layer that supports the plurality of the semiconductor structures,
wherein each of the plurality of the semiconductor structures comprises:
a P-type first semiconductor layer;
an N-type second semiconductor layer; and
a light-emitting layer located between the first semiconductor layer and the second semiconductor layer, and
wherein the plurality of the semiconductor structures forms a column having a polygonal or circular shape.

2. The semiconductor device of claim 1, wherein the plurality of the semiconductor structures are periodically spaced apart from each other and disposed on the connection support layer.

3. The semiconductor device of claim 1, wherein the connection support layer is a metal layer.

4. The semiconductor device of claim 1, wherein the connection support layer comprises at least one of a semiconductor and a metal oxide.

5. The semiconductor device of claim 1, wherein the plurality of the semiconductor structures are arranged so that a street line of the polygonal or circular shape versus an area ofthe polygonal or circular shape is minimized.

6. The semiconductor device of claim 1, wherein a boundary between the plurality ofthe semiconductor structures is formed depending on a semiconductor crystal structure ofthe plurality of the semiconductor structures.

7. A light-emitting diode device comprising:
a P-type first semiconductor layer;
an N-type second semiconductor layer; and
a light-emitting layer located between the first semiconductor layer and the second semiconductor layer, the light-emitting diode device forming a column having a polygonal or circular shape.

8. The light-emitting diode device of claim 7, wherein the light-emitting diode device is arranged so that a street line of the polygonal or circular shape versus an area of the polygonal or circular shape is minimized.

9. The light-emitting diode device of claim 7, wherein an outer boundary of the light-emitting diode device is formed depending on a semiconductor crystal structure of the plurality of the semiconductor structures.

10. A method for manufacturing a semiconductor, the method comprising:
forming a semiconductor structure layer on a substrate;
depositing a metal layer on a surface of the semiconductor structure layer;
exposing the semiconductor structure layer by separating the semiconductor structure layer and the metal layer from the substrate;
forming a plurality of individual semiconductor devices having a polygonal or circular shape by etching the semiconductor structure layer according to a first mask pattern; and
separating the individual semiconductor devices from each other by dry-etching or wet-etching the metal layer according to a second mask pattern corresponding to the first mask pattern so that the metal layer remains as a plurality ofpolygonal or circular shapes.

11. The method of claim 10, wherein the forming the individual semiconductor devices comprises etching the semiconductor structure layer according to the first mask patter so that a street line of the polygonal or circular shape versus an area of the polygonal or circular shape is minimized, and
the separating the individual semiconductor devices comprises etching the metal layer according to the second mask pattern so that the street line of the polygonal or circular shape versus the area ofthe polygonal or circular shape is minimized.

12. The method of claim 10, wherein grid lines of the first mask pattern and the second mask pattern are formed depending on a crystal structure ofthe semiconductor structure layer.

13. A method for manufacturing a semiconductor, the method comprising:
forming a semiconductor structure layer on a substrate;
depositing a mask layer on a boundary region excluding a device region of a surface of the semiconductor structure layer, in which individual semiconductor devices are to be formed and which has a polygonal or circular shape;
depositing a metal layer on the device region of the surface of the semiconductor structure layer;
exposing the semiconductor structure layer by separating the semiconductor structure layer from the substrate;
forming a plurality of the individual semiconductor devices having the polygonal or circular shape by etching the semiconductor structure layer according to a mask pattern corresponding to the boundary region; and
separating the individual semiconductor devices from each other by removing the mask layer from the boundary region.

14. The method of claim 13, wherein the mask pattern is formed so that a length of the boundary region versus an area of the device region is minimized.

15. The method of claim 13, wherein a direction of a boundary between the device region and the boundary region is determined depending on a crystal structure of the semiconductor structure layer.

16. A method for manufacturing a semiconductor, the method comprising:
forming a plurality of semiconductor structures having a polygonal or circular columnar shape on a substrate;
depositing a metal layer on the surface of the plurality of the semiconductor structures;
exposing the plurality of the semiconductor structures by separating the plurality of the semiconductor structures and the metal layer from the substrate;
providing a first mask pattern corresponding to one or more semiconductor structure groups comprising selectively one or more of the plurality of the semiconductor structures; and
separating the one or more semiconductor structure groups from each other to form individual semiconductor devices by dry-etching or wet-etching the plurality of the semiconductor structures and the metal layer using the first mask pattern.

17. A method for manufacturing a semiconductor, the method comprising:
forming a plurality of semiconductor structures having a polygonal columnar or circular columnar shape on a substrate;
providing a first mask pattern corresponding to one or more semiconductor structure groups comprising one or more of the plurality of the semiconductor structures;
depositing a mask layer on a boundary region other than the one or more semiconductor structure groups using the first mask pattern;
depositing a metal layer corresponding to the one or more semiconductor structure groups using a second mask pattern corresponding to the first mask pattern;
separating and removing the substrate from the plurality of the semiconductor structures;
forming individual semiconductor devices corresponding to the one or more semiconductor structure groups by dry-etching or wet-etching the plurality of the semiconductor structures using the first mask pattern; and
separating the individual semiconductor devices from each other by removing the mask layer from the boundary region.

18. A method for manufacturing a semiconductor, the method comprising:
forming on a substrate a plurality of semiconductor structures which have a polygonal columnar or circular columnar shape and are periodically spaced apart from each other;
depositing a metal layer on the plurality of the semiconductor structures or on a boundary between the semiconductor structures;
irradiating the substrate with a laser, which corresponds to a shape of one of the plurality of the semiconductor structures or a shape of a group including two or more of the plurality of the semiconductor structures and has a uniform beam profile, in a direction perpendicular to the substrate so that the laser is absorbed into a boundary between the plurality of the semiconductor structures and the substrate; and
separating one or more of the plurality of the semiconductor structures from the substrate by the absorbed laser.

19. A method for manufacturing a semiconductor, the method comprising:
forming a semiconductor structure layer on a substrate;
depositing a mask layer on a boundary region excluding a device region of a surface of the semiconductor structure layer, in which individual semiconductor devices are to be formed and which has a polygonal or circular shape;
depositing a first metal layer on the device region of the surface of the semiconductor structure layer;
removing the mask layer from the boundary region;
depositing a second metal layer on the boundary region and the first metal layer;
exposing the semiconductor structure layer by separating the semiconductor structure layer from the substrate;
forming a plurality of the individual semiconductor devices having a polygonal columnar or circular columnar shape by etching the semiconductor structure layer according to a mask pattern corresponding to the boundary region; and
separating the individual semiconductor devices from each other by etching a portion of the second metal layer, deposited on the boundary region, according to the mask pattern corresponding to the boundary region.

20. A computer-readable recording medium wherein a program for executing the method of any one of claims 1 to 19 is recorded.

21. A light-emitting diode device having a light-emitting side surface which has a polygonal or circular shape,
the light-emitting diode device comprising:
at least one electrode disposed adjacent to at least one ofthe corners ofthe light-emitting side surface ofthe light-emitting diode;
an outer finger which is connected to the electrode and spaced apart from the light-emitting side surface of the light-emitting diode and also disposed on the light-emitting side surface;
an inner finger which is spaced apart from the outer finger and disposed on the light-emitting side surface; and
a connection finger that connects the at least one electrode, the inner finger and the outer finger to each other.
